(19)

**Europäisches Patentamt**
**European Patent Office**
**Office européen des brevets**

(11) **EP 4 560 292 A1**

(12) **EUROPEAN PATENT APPLICATION**

(43) Date of publication:
**28.05.2025 Bulletin 2025/22**

(21) Application number: **23211526.1**

(22) Date of filing: **22.11.2023**

(51) International Patent Classification (IPC):
**G01N 17/02** *(2006.01)* **G01N 27/60** *(2006.01)*
**G01R 31/26** *(2020.01)* **G01N 27/00** *(2006.01)*

(52) Cooperative Patent Classification (CPC):
**G01N 27/60; G01N 13/02; G01R 31/2648;**
G01N 2013/0241; G01N 2013/0283

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Max-Planck-Gesellschaft zur Förderung der Wissenschaften e.V.**
**80539 München (DE)**
• **Technische Universität Darmstadt**
**64289 Darmstadt (DE)**

(72) Inventors:
• **Weber, Stefan**
**55128 Mainz (DE)**
• **Ratschow, Aaron Daniel**
**64289 Darmstadt (DE)**
• **Bista, Pravash**
**55128 Mainz (DE)**
• **Butt, Hans-Jürgen**
**55128 Mainz (DE)**

(74) Representative: **v. Bezold & Partner**
**Patentanwälte - PartG mbB**
**Ridlerstraße 57**
**80339 München (DE)**

(54) **POTENTIAL MEASURING APPARATUS AND METHOD FOR DETERMINING A PHYSICOCHEMICAL SURFACE PROPERTY BASED ON A SURFACE POTENTIAL AT A SOLID SAMPLE SURFACE**

(57) A potential measuring apparatus 100 for determining a physicochemical surface property based on a surface potential at a sample surface 2 of a solid sample 1, like the surface potential and/or a zeta potential of the sample surface 2, comprises a sample support 10 being arranged for accommodating the sample 1, a drop supply device 20 being arranged for placing a liquid probe drop 3 on the sample surface 2, a drop movement device 30 being arranged for providing a sliding movement of the probe drop 3 along a predetermined sliding path 4 on the sample surface 2, an electrode measuring device 40 being arranged for sensing an electrical quantity including at least one of a drop voltage and a drop charge of the probe drop 3 after passing the sliding path 4, wherein the electrode measuring device 40 includes a probe electrode 41 arranged at a downstream end of the sliding path 4 and a measuring circuit 42 coupled with the probe electrode 41, and a calculation device 50 being adapted for determining the physicochemical surface property based on the electrical quantity. Furthermore, a potential measuring method for determining a physicochemical surface property based on a surface potential at a sample surface 2 of a solid sample 1 is described.

FIG. 1

## Description

Field of the invention

The invention relates to a potential measuring apparatus and methods for determining a physicochemical surface property based on a surface potential at a sample surface of a solid sample, in particular for determining the surface potential and/or a zeta potential of the sample surface. Applications of the invention are available e. g. in the fields of physical chemistry and surface techniques, e. g. characterizing sample surfaces.

Prior art

In the present specification, reference is made to the following prior art illustrating the technical background of the invention:

[1] A. Z. Stetten, D. S. Golovko, S. A. Weber, and H.-J. Butt in "Soft Matter" 15, 8667 (2019);
[2] S. Lin et al. in "Nature communications" 11, 1 (2020);
[3] J. Zhang et al. in "ACS nano" 15, 14830 (2021);
[4] L. E. Helseth in "Langmuir" 35, 8268 (2019);
[5] W. S. Wong et al. in "Langmuir" 36, 7236 (2020);
[6] R. Zimmermann et al. in "Physical Chemistry Chemical Physics" 11, 4360 (2009);
[7] K. N. Kudin et al. in "Journal of the American Chem ical Society" 130, 3915 (2008);
[8] L. S. McCarty et al. in "Angewandte Chemie International Edition" 47, 2188 (2008);
[9] M. D. Sosa et al. in "Soft Matter" 16, 7040 (2020);
[10] M. Kowacz et al. in "The Journal of Physical Chemistry B" 123, 11003 (2019);
[11] R. J. Hunter in "Foundations of Colloid Science", 2nd ed. (Oxford University Press, Oxford, 2001) chapter 7.9, pages 356-361;
[12] H.-J. Butt et al. in "Physics and Chemistry of Interfaces", 1st ed. (Wiley-VCH, Weinheim, 2006, chapter 4, pages 45-59);
[13] M. D. Sosa et al. in "Langmuir" 38, 8817 (2022);
[14] A. D. Ratschow et al. "How charges separate when surfaces are dewetted" Preprint 2023;
[15] T. Hiemstra et al. in "Journal of colloid and interface science" 133, 105 (1989);
[16] S. Chen et al. in "Sensors 20, 1690 (2020);
[17] S. H. Behrens et al. in "The Journal of chemical physics" 115, 6716 (2001);
[18] E. J. van der Wouden et al. in "Lab on a chip" 6, 1300 (2006);
[19] P. Vogel et al. "Journal of the American Chemical Society" 144, 21080 (2022);
[20] L. E. Helseth in "Langmuir" 39, 1826 (2023);
[21] B. J. Kirby et al. in "Electrophoresis" 25, 187 (2004); and
[22] D. I. Diaz et al. "Charging of impacting drops onto superhydrophobic surfaces" in "Soft Matter" 18. 10.1039/D1SM01725J., 2022;

The surface potential, $\Phi$, is a physical quantity of solid-liquid-interfaces which is generally known in physical chemistry. It quantifies the electrical charge on a surface of a solid when it comes into contact with a liquid. The surface potential generally may be used for describing charge separation (or: charge transfer) processes at solid surfaces in polar liquids. As an example, in water, practically all solid surfaces are charged. The charging of solid surfaces in liquids is responsible for various effects and behaviors, e.g., in physical chemistry and process engineering.

The surface potential is one of the key parameters in colloid and surface science, and it can be used for describing e.g., the stability of suspensions (dispersions) and emulsions, electrokinetic phenomena, catalytic activity, and corrosion. It also plays a role in determining contact angles and the thickness of thin liquid films [16]. Additionally, the surface potential is crucial for biological and technical membranes.

Measuring electrical properties and in particular the surface potential at solid-liquid-interfaces is challenging. For dispersed particles, surface potentials, in particular the so-called Zeta potential, can be measured using techniques like electrophoresis or electroacoustics. These methods are, however, not very reliable and restricted to liquids with low salt concentration. Furthermore, surface charge densities can be determined through titration for certain charging mechanisms. This process is, however, quite laborious and depends on several assumptions. In the case of planar surfaces, streaming potentials or AFM force measurements can provide information about the surface potential. However, these methods are often expensive, imprecise, and rely on multiple assumptions.

Spontaneous charging of moving drops (or: slide electrification) has been observed, e.g., in mi-cropipetting, aerosolizing, bouncing, squeezing or sliding of drops (see e.g., [1-2]). This spontaneous charging is caused by the charge separation at solid surfaces in liquids. Applications of charge separation at sliding drops may be found e.g., in energy harvesting or sensing.

It is known that the surface charge at solid-liquid interfaces is related to the surface potential which may be described as the electrostatic potential at the transition between immobilized counter charges in the so-called Stern layer and the diffuse Debye layer and the liquid outside of the diffuse Debye layer. Because of the high capacitance of the Stern layer [15], the often cited zeta potential at the shear plane and the surface potential are almost indistinguishable for Debye lengths above 1 nm.

Although the phenomenon of charge separation in moving drops has been observed qualitatively for decades, a quantitative understanding of the physical process is strongly limited. One proven way to study slide electrification is to measure a discharge current of a drop after sliding down a tilted hydrophobic plate [1-4]. Using this method, it has been found that the drop charge saturates after a sliding path of a few cm. Furthermore, a dependence of the drop charge on the surface chemistry [5] and a drop-number dependence during a sequence of drops [13] have been found.

The phenomenon of the charge separation is commonly attributed to ionic charges [6-10]. In water or high dielectric liquids, most solid surfaces are charged. These surface charges form spontaneously, e.g. by the adsorption of ions from solution, by protonation or deprotonation of surface groups or the preferential dissolution of ions, leading to the formation of an electrostatic double layer (EDL)[11, 12]. It has been shown that the contact electrification is correlated to the zeta-potential, pH and salt concentration of the liquid [13]. Previous models were based on the assumption that some of the charge from EDL is left behind on the solid surface as the contact line moves. Recently, this charge transfer mechanism at receding contact lines and its parametric dependencies were described theoretically [14].

Previous measurements and models do not allow to quantify the surface potential. There is continued interest in modelling charge transfer at sliding drops and in quantitative measurements of the surface potential or related quantities, e.g., for characterizing charge separation at solid-liquid-interfaces.

Objective of the invention

The objective of the invention is to provide an improved potential measuring apparatus and method for determining a physicochemical surface property based on a surface potential at a sample surface of a solid sample, in particular for determining the surface potential and/or a zeta potential of the sample surface, being capable of avoiding limitations of conventional techniques. In particular, the objective of the invention is to provide a new potential measuring apparatus and method being capable of measuring the surface potential and/or a zeta potential of the sample surface or a related physicochemical surface property with reduced complexity, reduced costs, improved precision, extended applications and/or simplified measuring conditions.

Summary of the invention

These objectives are correspondingly solved by a potential measuring apparatus and a potential measuring method comprising the features of the independent claims, respectively. Preferred embodiments and applications of the invention arise from the dependent claims.

According to a first general aspect of the invention, the above objective is solved by a potential measuring apparatus, being configured for determining a physicochemical surface property based on a surface potential at a sample surface of a solid sample, in particular in contact with a liquid, comprising a sample support being arranged for accommodating the sample, a drop supply device being arranged for placing a liquid probe drop (made of the liquid to be employed for investigating the sample) on the sample surface, a drop movement device being arranged for providing a sliding movement of the probe drop along a predetermined sliding path on the sample surface, and an electrode measuring device being arranged for sensing an electrical quantity including at least one of a drop voltage and a drop charge of the probe drop after passing the sliding path, wherein the electrode measuring device includes a probe electrode arranged at a downstream end of the sliding path and a measuring circuit coupled with the electrode.

According to the invention, the potential measuring apparatus further comprises a calculation device being adapted for determining the physicochemical surface property based on the electrical quantity. The term "calculation device" refers to any processor unit, in particular being configured for executing a software, like a computer or a calculator, and being coupled with and/or integrated in the measuring circuit of the electrode measuring device and allowing the determination, in particular calculation of the physicochemical surface property. The calculation device may be directly coupled with and/or integrated in the measuring circuit, or it may be provided at a distant location and arranged for coupling with the measuring circuit of the electrode measuring device via a data transfer connection, like a network connection. With an advantageous example, the surface potential or related quantity to be obtained may be determined by a data acquisition device included in the electrode measuring device.

According to a second general aspect of the invention, the above objective is solved by a potential measuring method for determining a physicochemical surface property based on a surface potential at a sample surface of a solid sample, comprising the steps of placing a liquid probe drop on the sample surface, providing a sliding movement of the probe drop along a predetermined sliding path on the sample surface, and sensing an electrical quantity including at least one of a drop voltage and a drop charge of the probe drop after passing the sliding path.

According to the invention, the potential measuring method further comprises a step of determining the physicochemical surface property, in particular at least one of the surface potential and a zeta potential of the sample surface, based on the electrical quantity. Preferably, the potential measuring method or an embodiment thereof is executed with the potential measuring apparatus according to the first general aspect of the invention or an embodiment thereof.

The invention is based on the knowledge, that a drop of polar liquid, like e.g., water, sliding on an electrically insulating, e.g., hydrophobic, sample surface can generate an electric potential, e.g., up to kilovolts, and/or collect an electrical charge. The electric potential and/or the charge can be measured, e.g. by measuring an electrical voltage relative to a reference potential, e.g., relative to ground potential, and/or measuring an electrical current.

The inventors have found improved techniques to measure the potential and/or capacitance of drops providing the electric potential and the charge (or drop voltage and/or drop current) to be obtained. In particular, the inventors have found that some electric effects have been ignored in [1], resulting in limitations in the conventional measurement. In particular, the inventors have improved the measurement setup compared with [1], so that the precision of the quantitative measurement of the electrical quantity has been substantially improved. Furthermore, the inventors have found that the measured drop voltage and/or drop charge is a function of the surface potential at the liquid-sample interface. Thus, the invention is based on a relation between firstly the drop voltage and/or charge and secondly the surface potential as found by the inventors. Thus, the inventors provide for the first time measuring the drop charge or drop voltage of a moving drop and determining, in particular calculating, the surface potential and/or related quantities at the solid-liquid interface from the drop charge and/or drop potential.

In particular, the inventors have found for the first time a quantitative model describing the charge transfer process during the sliding movement, said quantitative model including the surface potential and further known parameters, like in particular at least one property of substrate geometry, at least one dielectric property, and Debye length. Advantageously, the inventors have demonstrated a reliable way of measuring the drop voltage and/or charge with reduced complexity, so that a new low-cost method for measuring surface potentials and/or related quantities is obtained.

The term "physicochemical surface property" refers to the surface potential and/or the zeta potential of the sample surface or any quantity being determined by the charge separation at the sample-liquid interface and being related to the surface potential and/or the zeta potential. Accordingly, with a preferred embodiment of the invention, the calculation device may be adapted for determining at least one of the surface potential and a zeta potential of the sample surface. Alternatively, another physicochemical surface property may be calculated, which is derived from the surface potential and/or the zeta potential of the sample surface, like e.g., the surface charge density calculated using the Gouy-Chapman theory.

The sample support may be provided by a separate, electrically conductive component carrying the sample during the measurement, or the sample may be integrated in a dielectric sample support being provided with an electrode layer. In the latter case, the surface of the sample support may provide the sample surface.

The sliding path is a track on the sample surface. The probe drop is moved along the sliding path by the drop movement device. The sliding path begins at a location where the probe drop is placed on the sample surface, or optionally downstream from the placement at a location, where the probe drop is neutralized by a grounding electrode. The sliding path ends at a location of a probe electrode for sensing the electrical quantity of the probe drop.

The length of the sliding path preferably may be selected to be equal or larger than a saturation slide length. Preferably, after passing the saturation slide length, the collection of charges on the probe drop is saturated and/or the drop voltage is saturated (see [1]), i.e., the collection of charges on the probe drop and/or the drop voltage do not further change after passing the slide length required for the drop charge to saturate (or further changes are neglectable, see below). Usually, the probe drop may further move after passing the end of the sliding path, i.e., after passing the probe electrode.

The collection of charges toward saturation is an approximation process, e.g., an exponential process. For example, the exponential process means that after a characteristic slide length L, 63% of the charge is reached, and after 2*L 95% and after 3*L a little over 99% and therefore practically equilibrium of the charge is reached. Preferably, the length of the sliding path may be selected to be equal or larger than the characteristic saturation slide length, particularly preferred equal or larger than 3 times the characteristic saturation slide length. The characteristic saturation slide length for drop charge saturation $L_{sat}$ may be estimated according to $L_{sat} = \pi * w/(4*\alpha)$, where w is the width of the probe drop perpendicular to the direction of sliding and the charge transfer coefficient $\alpha$ may be e.g., about 0.25. In practice, the charge transfer coefficient $\alpha$ may be lower or larger, e.g., 0.5, than this example. The charge transfer coefficient $\alpha$ may be measured e.g., by a separate saturation measurement. Thus, the electrical quantity sensed with the electrode measuring device preferably may comprise a saturation voltage and/or a saturation charge of the probe drop.

The sample thickness influences the sensing of the electrical quantity with the electrode measuring device. Generally, the sample thickness is determined e.g., by a separate thickness measurement. Preferably, the thickness is in a

range from 100 $\mu$m to 10 mm, particularly preferred in a range from 1 mm to 5 mm.

The drop size may be selected in dependency on the measuring conditions. As a general rule, the larger the probe drop, the larger are the contact area with the sample and the drop capacity, so that more charge is collected. However, the saturation may be reached later, so that the length of the sliding path is increased. An optimum in consideration of these parameters can be found with the particular measuring conditions. With practical examples, a drop diameter may be at least 0.3 mm, in particular at least 0.5 mm and at most 5 mm, in particular at most 4 mm. Depending on the liquid and sample materials, drops with a diameter below 0.3 mm might not slide, and drops larger than 5 mm may deform substantially and thus not keep a well-defined width over the measurement. Generally, a limiting length scale here is the so called "capillary length" of the liquid. The drop radius preferably should not exceed 2 times the capillary length, which is 2 mm for water.

According to a preferred embodiment of the invention, the calculation device may be adapted for determining the physicochemical surface property, in particular the surface potential and/or the zeta potential, based on a proportional relationship between the surface potential and/or the zeta potential and the electrical quantity. In terms of the method, the surface potential and/or the zeta potential preferably may be calculated based on a proportional relationship between the surface potential and/or the zeta potential and the electrical quantity sensed. In particular, the surface potential and/or the zeta potential may be calculated by multiplying the sensed electrical quantity with an amplification factor. The amplification factor can be determined based on the inventive charge transfer model and/or by a calibration measurement. In particular, the amplification factor includes known parameters of the measurement, in particular a ratio of the dielectric permittivities of liquid and sample and a ratio of sample thickness d and Debye length $\lambda_D$. Advantageously, the quantitative model found by the inventors allows a calculation with low complexity, directly on the basis of the sensed electrical quantity, in particular drop voltage and/or drop charge.

Preferably, the drop movement device may be provided by the sample support being configured for accommodating the sample with an inclined arrangement so that a surface normal direction of the sample surface deviates from the gravity direction and the sample support is arranged for creating the sliding movement of the probe drop by gravity force. Moving the probe drop by gravity offers advantages in particular in terms of reduced complexity and costs of the measuring set-up.

Particularly preferred, the sample support may be configured for accommodating the sample with the inclined arrangement so that an inclination angle between the surface normal direction and the gravity direction is in a range between 20° to 70°, e.g., in a range between 40° to 70°. With these preferred angle ranges, optimization of drop velocity in terms of a reliable measurement is obtained.

Alternatively or additionally, the drop movement device may comprise a drop shifting device being configured for exerting a shifting force on the probe drop and for creating the sliding movement of the probe drop by the shifting force. Advantageously, the drop shifting device allows a precise and reproducible adjustment of the drop velocity. In particular, the drop velocity may be set independently of a drop size. Furthermore, unintended adhering of the probe drop at the probe electrode can be excluded with improved reliability.

Particularly preferred, the drop shifting device may comprise at least one of an electrically insulating shifting tool being arranged for contacting the probe drop and exerting the shifting force on the probe drop, wherein at least one of the shifting tool and the sample support are arranged for a movement relative to each other, and a pressure device being arranged for creating a pressure gradient along the sample surface of the solid sample. The shifting tool, like a movable slider tool, may have particular advantages resulting from the direct, adjustable exertion of the shifting force. Advantages of the pressure device, like a nozzle device creating a shifting gas flow or a capillary including a shifting gas flow, may result from excluding electrical effects of exerting the shifting force on the probe drop.

Accordingly, in terms of preferred embodiments of the inventive method, the sliding movement of the probe drop may be created by one of an inclined arrangement of the sample, so that the sliding movement of the probe drop is created by gravity force, and exerting a shifting force on the probe drop and creating the sliding movement of the probe drop by the shifting force.

Generally, both of the drop voltage and charge can be sensed as the electrical quantity of the probe drop after sliding along the sample surface. Advantageously, sensing one of both quantities, i.e., drop voltage or drop charge, is sufficient for obtaining the electrical quantity, which is used for determining the physicochemical surface property.

According to a further preferred embodiment of the invention, the electrode measuring device may be arranged for sensing the drop charge of the probe drop after passing the sliding path, wherein the measuring circuit includes a current measuring component, like a current amplifier, in particular a transimpedance amplifier, and an integrator unit, wherein the current measuring component is configured for measuring a discharge current from the probe drop to the probe electrode and the integrator unit is configured for integrating the measured discharge current. The term "integrator unit" refers to any processor unit, in particular running a software, like a computer or a calculator, being coupled with the transimpedance amplifier and allowing the integration of the discharge current. On the basis of the sensed drop charge and a measured or calculated drop capacitance, a drop voltage may be calculated.

According to another preferred embodiment of the invention, the electrode measuring device may be arranged for sensing the drop voltage at the probe drop after passing the sliding path, wherein the measuring circuit includes a probe capacitance connected between the probe electrode and a reference potential, in particular ground potential, and a voltage acquisition circuit arranged for direct voltage measurement at the probe capacitance. This embodiment has advantages in terms of reduced complexity of the measuring circuit.

Alternatively or additionally, the electrode measuring device may be arranged for sensing the drop voltage at the probe drop after passing the sliding path, wherein the measuring circuit includes a variable voltage source connected with the probe electrode, a current measuring component, like e.g., a current amplifier connected via the voltage source with the probe electrode and a control loop being arranged for adjusting the voltage source to a compensation voltage such that the current measuring component does not sense a discharge current from the probe drop, wherein the compensation voltage provides the drop voltage to be sensed.

This voltage compensation based embodiment may be executed by a measurement with a single drop. In particular, one might pull the drop and compensate the voltage generated by the drop. If the voltage is not reached, then the same drop can be moved on the surface again. With further details, a single drop may be moved, while in contact with the probe electrode. The current through the probe electrode is sensed and additionally, the voltage of the probe electrode can be set. A feedback loop control controls the voltage so that the current is 0. The voltage required with this embodiment is physically identical to the saturation voltage sensed in the other methods.

Alternatively, voltage compensation based embodiment may be executed with a measurement of a series of probe drops, each being subjected to another voltage until the compensation voltage is found providing a value of the drop voltage to be obtained.

Accordingly, in terms of preferred embodiments of the inventive method, the drop charge at the probe drop may be sensed after passing the sliding path by measuring a discharge current from the probe drop to the probe electrode and integrating the measured discharge current, and/or the drop voltage at the probe drop may be sensed after passing the sliding path by connecting a probe capacitance between the probe electrode and a reference potential, in particular ground potential, charging the probe capacitance with the probe drop and measuring the drop voltage at the probe capacitance, and/or the drop voltage at the probe drop may be sensed after passing the sliding path by applying a compensation voltage to the probe drop such that no discharge current from the probe drop occurs, wherein the compensation voltage provides the drop voltage to be sensed.

Further advantages of the invention result from the multiple design options in the configuration of the potential measuring apparatus. According to a preferred variant, the drop supply device may comprise a drop dispenser. The drop dispenser may be arranged for targeted depositing, e.g., dripping the probe drop at a predetermined position on the sample surface. The drop dispenser may have advantages in terms of controlling the drop deposition on the sample surface.

According to a further preferred variant, the probe electrode may be arranged with a distance from the sample surface. Accordingly, electrical interactions between the probe electrode and the sample are avoided. The distance preferably is equal to or smaller than a height of the probe drop when contacting the probe electrode.

The probe electrode may be arranged for a contact with the moving probe drop when the drop passes the probe electrode. The electrode measuring device preferably may be arranged for sensing the electrical quantity at the moving probe drop. Preferably, the shape of the probe electrode may be selected such that the probe drop is not adhered at the probe electrode. The probe electrode may comprise a wire-shaped, preferably tip-shaped, electrode with a wire section, preferably electrode tip, facing to the sliding path. It is not necessary that a wire tip contacts the probe drop. As an alternative to the tip-shaped electrode, another wire section may be in contact the probe drop, like e.g., a linear wire arrangement or a loop-shaped wire arrangement.

According to a further preferred variant, the drop supply device may comprise a drop shaping device being arranged for broadening the probe drop placed on the sample surface and at the same time minimizing the contact area. With broadening the probe drop, a contact line of the drop at a trailing edge of the sliding drop is broadened, thus increasing the charge transfer and shortening the saturation slide length in an advantageous manner.

The potential measuring apparatus may be configured for a single drop measurement. Accordingly, the physicochemical surface property may be determined based on the electrical quantity sensed with a single drop only.

Alternatively, the drop supply device may be arranged for placing multiple liquid probe drops on the sample surface, the drop movement device may be arranged for providing the sliding movement of each of the probe drops along one or more predetermined sliding paths on the sample surface, wherein each of the one or more sliding paths is assigned to one of the probe drops, the electrode measuring device may be arranged for sensing the electrical quantity of each of the probe drops after passing the corresponding sliding path, and the calculation device may be adapted for determining the physicochemical surface property based on the electrical quantities sensed with all of the probe drops. The multiple drops measurement may have advantages in terms of improved precision of the measurement.

Further preferred features of the inventive method may be provided as follows. The sample surface generally may be a hydrophobic surface for supporting the drop formation. The sample surface is a hydrophobic surface if the liquid forms some contact angle with the sample surface. Preferably, the contact angle at least 45°, e.g. at least 50°, 60°, 75°, 90° or even 110°. With samples having this characteristic, advantages for investigating liquids including water or watery solutions are obtained. According to a further preferred variant, the sample surface may be a plane surface. Alternatively, the sample surface may be a curved surface, like an inner surface of a capillary. Alternatively or additionally, the sample surface may be a structured surface, including e.g. micro- and/or nanostructures.

Advantageously, the invention can be executed with a broad range of probe liquids, which preferably are capable of forming an electric double layer at the sample surface, wherein the width of the electric double layer (Debye length) scales with the dielectric permittivity. Preferably, the relative dielectric permittivity exceeds 20. Particularly preferred, the probe liquid may comprise a polar liquid, in particular water or a watery solution or ethanol, optionally including an ionic salt. Preferably, an ion concentration of the liquid is selected such that the Debye length (calculable via valences of the electrons in liquid at a known concentration and/or measurable via conductivity of the liquid) is at least 1 nm.

Features disclosed in the context of the potential measuring apparatus and embodiments thereof also represent preferred features of the inventive potential measuring method or embodiments thereof. The disclosed aspects and inventive and preferred features, in particular with regard to the configuration of the potential measuring apparatus as well as the dimensions and compositions of individual components being described in relation to the potential measuring apparatus, also apply for the potential measuring method. The preferred embodiments, variants and features of the invention described above are combinable with one another as desired.

Brief description of the drawings

Further details and advantages of the invention are described in the following with reference to the attached drawings, which schematically show in:

Figures 1 to 3:	illustrations of features of a potential measuring apparatus according to preferred embodiments of the invention;

Figures 4 to 9:	experimental results obtained with the potential measuring apparatuses of Figures 1 to 3;

Figure 10:	an illustration of the electric fields present at the solid-liquid interface; and

Figures 11 to 13:	illustrations of features of potential measuring apparatuses according to modified embodiments of the invention.

Preferred embodiments of the invention

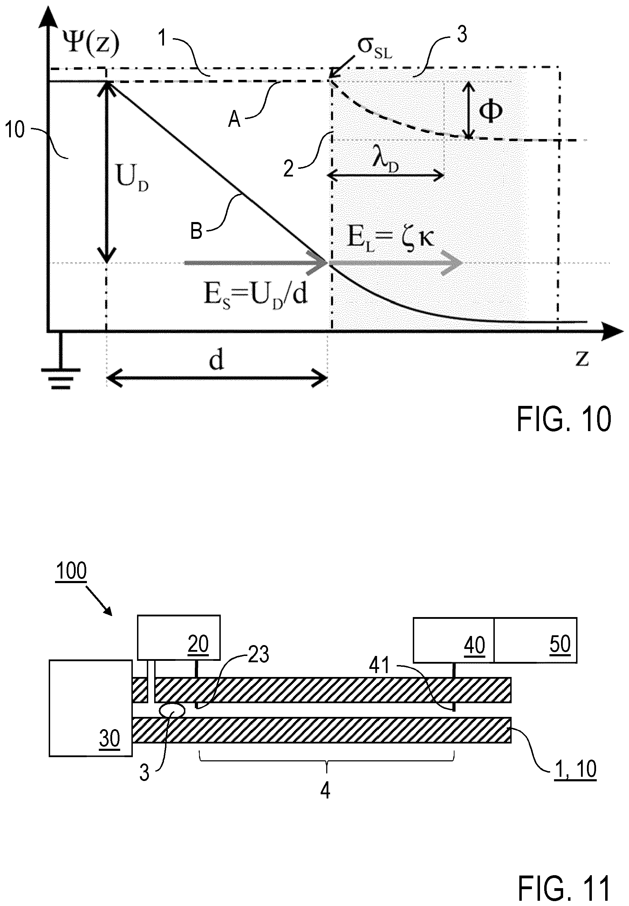

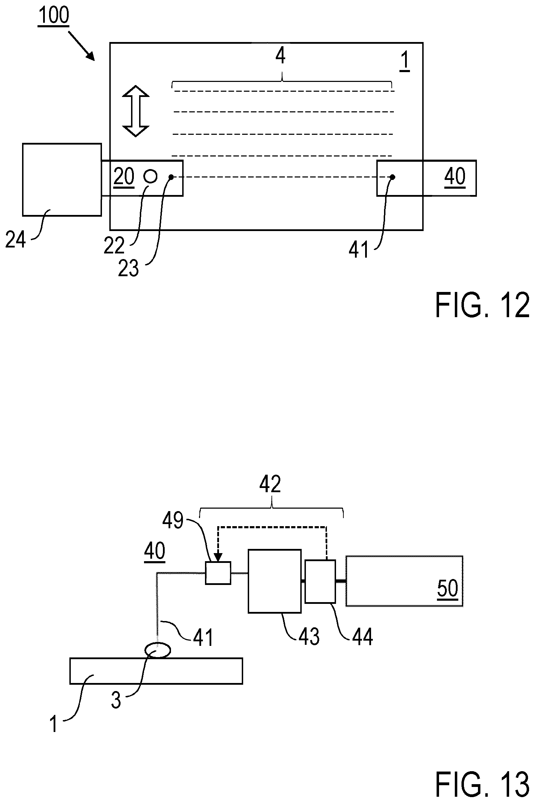

Features of preferred embodiments of the invention are described in the following with exemplary reference to a potential measuring apparatus, wherein the drop movement device is provided by a sample support with an inclined arrangement. The invention is not restricted to the particular configuration with the inclined sample support, but rather can be executed with other configurations of the drop movement device (see e.g., Figure 11), with a horizontal or optionally in combination with an inclined sample support. Some details of the potential measuring apparatus are not described as far as they are known per se from prior art, e.g., as described in [1]. The potential measuring apparatus is shown with a single sliding path. Multiple sliding paths can be provided in a modified potential measuring apparatus, in order to measure multiple probe drops serially or in parallel (see e.g., Figure 12) and/or to map spatial variations in the physicochemical surface property of the sample.

Exemplary reference is made to a plane, non-structured sample surface. Alternatively, the invention can be employed for determining a physicochemical surface property based on a surface potential at a structured sample surface. The sample surface may have nano-structures (structures with geometric features with characteristic dimensions below e.g., 10 $\mu$m. As an example, the sample surface may be provided with nanopillars or nanowalls. The inventors have found that nanostructures of the structured sample surface may cause field distortions, but still allow a charge transfer to the probe drop.

According to advantageous embodiments of the invention, potential measuring is obtained in particular by improved sensing of at least one of a drop voltage and a drop charge of a probe drop after passing a sliding path on a sample and determining the physicochemical surface property to be obtained, like the surface potential, from the sensed drop voltage and/or drop charge. In the following, embodiments of the potential measuring apparatus and method are described with reference to sensing the drop voltage and/or the drop charge of the probe drop, followed from a description of the inventive quantitative model of charge transfer, in particular for determining the physicochemical surface property. Finally, modified embodiments of the invention are described.

Embodiments of potential measuring apparatus and method

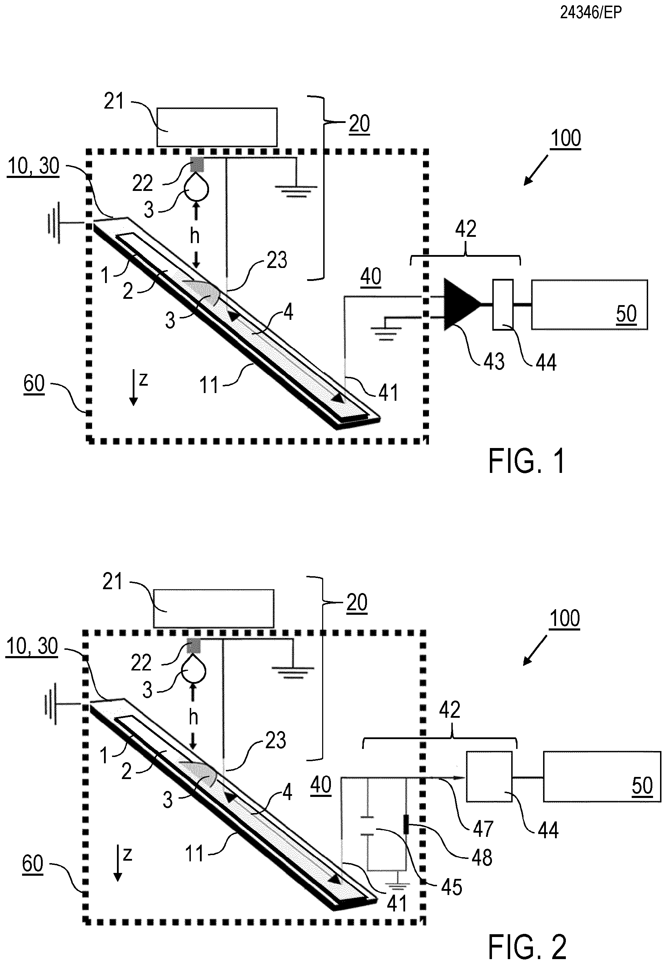

Figures 1 and 2 schematically illustrate embodiments of an inventive potential measuring apparatus 100, each comprising a sample support 10 for accommodating the sample 1 to be investigated, a drop supply device 20 for placing a liquid probe drop 3 on the sample surface 2 of the sample 1, a drop movement device 30 for providing a sliding movement of the probe drop 3 on the sample surface 2, an electrode measuring device 40 having a probe electrode 41 and a measuring circuit 42 for sensing at least one of a drop voltage and a drop charge of the probe drop after passing the sliding path, and a calculation device 50 for determining the physicochemical surface property, e.g., the surface potential based on the measured drop voltage or drop charge. The embodiments of Figures 1 and 2 have a similar configuration with regard to components 10 to 30 and 50, but differ in the configuration of the electrode measuring device 40.

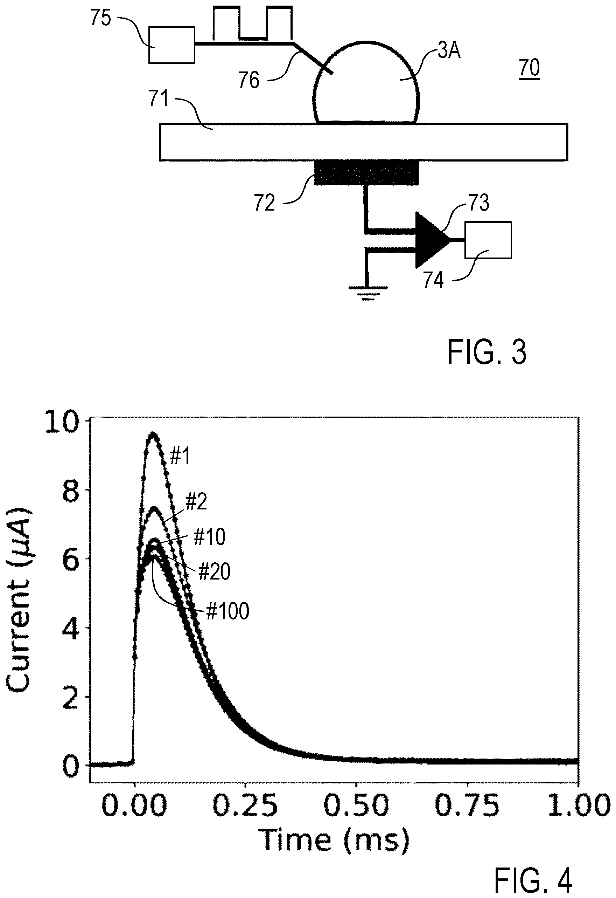

Optionally, a shielding device 60, like a Faraday cage, for shielding the sensitive components against external electromagnetic fields, and/or a separate capacitance measurement setup 70 (see Figure 3) for capacitance measurements may be provided.

For the experimental tests described below, the potential measuring apparatus 100 of Figures 1 and 2 is adapted for investigating for instance a plane coated glass plate (sample 1 to be investigated). The glass plate has an electrically conductive contact layer, made of e.g., gold, on a back side (placed on the sample support 10) and a sample surface 2 provided by the glass with a hydrophobic coating, made of e.g., (trichloro(1H,1H,2H,2H-perfluorooctyl)silane (PFOTS) on an exposed front side. The experiments are done under ambient conditions (temperature: $21 \pm 1°C$, humidity: 30-50%), where minimal influence of humidity and temperature has been reported [9]. Any initial surface charge is neutralized, e.g., by using an ionizing air blower (IAB, Simco-Ion Aerostat PC Ionizing air blower) for 2 minutes (air ion concentration to 300.000 ions/$cm^3$, measured with an Ionometer, IM806v3), and waiting some minutes until ions in the air dissipated and an equilibrium air ion concentration (200-400 ions/$cm^3$) is reached.

The sample support 10 as shown in Figures 1 and 2 comprises a grounded plane metal plate 11, e. g. made of aluminum. By placing the metal plate 11 with an inclination angle such that a surface normal direction of the sample support 10 and correspondingly the sample surface 2 deviates from the gravity direction (z direction), the sample support 10 simultaneously provides the drop movement device 30. The inclination angle is, e.g., 50°. By the effect of the gravitational force, a probe drop 3 placed on the sample surface 2 moves downwards along a sliding path 4.

The drop supply device 20 as shown in Figures 1 and 2 comprises a liquid reservoir 21, e.g., provided with a peristaltic pump (e.g., Gilson Minipuls 3, not shown), and a grounded metallic syringe 22. As an example, the syringe 22 has a 2 mm diameter, and it is adapted for producing liquid drops 3 of volume 45 μl. Drops 3 comprise e.g., deionized (DI) water (Sartorius Arium Pro VF, 18.2 MΩ resistivity, pH= $6.4 \pm 0.3$). The falling drops are electrically neutral. It is known that DI water may dissolve $CO_2$ from the atmosphere ([22], [10] and [19]), leading to a pH of around 6. Dissolved $CO_2$ can introduce HCO - ions in the drop in addition to OH- and H3O+ ([10]).

The syringe 22 is electrically connected with an optionally provided grounding electrode 23 having an exposed electrode tip and being arranged with a distance from the sample surface 2. The grounding electrode 23 marks a starting point of the sliding path 4 of probe drop 3. The grounding electrode 23 may comprise a thin metal grounding wire so that the drop motion is not influenced. The probe drop 3 from syringe 22 falls from a height h of e.g., $(0.5 \pm 0.2)$ cm and slides for e.g., $(1.0 \pm 0.2)$ cm to the grounding electrode 23, where it is electrically neutralized to begin the slide electrification measurement. In the experiments with series of drops, a drop interval time of $\Delta t = 1.8 \pm 0.2s$ between drops is used. Drop widths (w) and lengths (I) may be measured using a calibrated telecentric high-speed camera. From previous experiments, it was found for 45 μL drops: w = 5 mm, and I = 6.7 mm [1].

The grounding electrode 23 to ground the probe drop 3 may have an advantage for providing the sliding path with a defined length. Alternatively, the grounding electrode 23 may be omitted, if sensing the saturation charge or saturation voltage is otherwise obtained.

The electrode measuring device 40 generally is adapted for sensing an electrical quantity including the drop voltage and/or the drop charge of the probe drop 3 after passing the sliding path 4. The electrode measuring device 40 of Figure 1 is adapted for sensing the drop charge, and the electrode measuring device 40 of Figure 2 is adapted for sensing the drop voltage via a charge/capacitance measurement. It is sufficient to provide one of the electrode measuring devices 40 in a practical embodiment of the potential measuring apparatus 100. In alternative embodiments, both electrode measuring devices 40 may be combined in a common potential measuring apparatus 100.

In both embodiments according to Figures 1 and 2, the electrode measuring device 40 includes the probe electrode 41, which is arranged at a position with a distance downstream from the starting point of the sliding path 4, in particular from the grounding electrode 23. The sliding path 4 is provided by a straight line between the grounding electrode 23 and the probe electrode 41.

The probe electrode 41 has e.g., an exposed electrode tip being arranged with a distance from the sample surface 2. As an example, the probe electrode 41 may comprise a metal electrode with a tip diameter of e.g., 0.2 mm. The probe electrode 41 is arranged such that the drop sliding along the sliding path 4 electrically contacts the electrode tip for a contact time interval determined by the drop velocity, e.g., 15 cm/s to 50 cm/s. The probe electrode 41 may be shaped and dimensioned such that the probe drop 3 is able to pass the probe electrode 41 without adhering at the electrode tip. As an alternative to the electrode tip, another section of an electrode may be used for the electrical measurement, e.g., a wire section which is tangentially contacted by the sliding drop 3, preferably without catching it.

After getting neutralized at the grounding electrode 23, the probe drop 3 then slides a known distance (accuracy of L $\pm$ 0.2 cm) to the metal probe electrode 41. A laser trigger system, e.g., comprising a 657 nm laser diode (CPS186, Thorlabs) and a laser detector (not shown) may be placed before the probe electrode 41 and used as a trigger for data acquisition.

According to the embodiment of Figure 1, for sensing a (saturation) drop charge via measuring a discharge current at the probe drop 3, the measuring circuit 42 comprises a current amplifier 43 (in particular transimpedance amplifier), like a sub-femtoampere current amplifier (e.g., FEMTO DLPCA-200; rise time: 0.7-1.8 $\mu$s) and a data acquisition device 44 (e.g., national instrument data acquisition board, NI card NI USB-6366 x-Series). The current measurement yields a signal as shown in exemplary manner for a series of drops in Figure 4. To calculate the accumulated drop charge Q over the chosen slide length of sliding path 4, the initial peak of the measured current signal within a first interval of e.g., 0.5 ms of drop probe contact is integrated. To this end, an integrator unit is provided in the data acquisition device 44 for integrating the measured discharge current.

Based on the drop charge Q and the drop capacitance $C_D$, the (saturation) drop voltage $U_D$ can be obtained according to $U_D = Q/C_D$. The drop capacitance $C_D$ can be estimated by calculation based on the system's geometry or with a separate measurement setup 70 (schematically shown in Figure 3). According to the first variant, a plate capacitor geometry may be assumed and the drop capacitance $C_D$ may be estimated using the formula $C_D = \epsilon_0 \epsilon_r \dfrac{A}{d}$, where $\epsilon_0$ is vacuum permittivity, $\epsilon_r$ is the dielectric permittivity of the substrate, $A = \pi l w/4$ represents the drop's base area, l is the drop length, w the drop width, and d is the sample thickness. According to the second variant, a probe drop 3 with the same volume like the probe drop 3 investigated is placed on an upper side of a substrate 71, e.g., a 3 mm glass plate, having an electrode 72 on an opposite lower side thereof (see Figure 3). To measure the capacitance of the drop-surface system, the capacitor is charged up externally by a voltage source 75 via an electrode 76 using a potential, V, and the charge, Q, in the capacitor system is measured with the current amplifier 73 and a data acquisition unit 74. Using Q and V, for instance for a 45 $\mu$L probe drop 3A, an average $C_D = 0.47 \pm 0.09$ pF was estimated. Tests by the inventors have shown that the estimated and measured capacitance values of the above first and second variants are in good agreement.

As shown in Figure 2, the measuring circuit 42 may be adapted for a voltage measurement on an input capacitor 45. The input capacitor 45 can be configured externally. The input capacitor 45 (e.g., 1 nF) is connected in parallel with the input of the data acquisition device 46, like an NI card. Once the probe drop 3 is in contact with the probe electrode 41, the drop discharges into the input capacitor 45 ($C_{in}$) until the voltages have equalized. The measured voltage depends on the capacitance ratio between $C_{in}$ and the drop capacitance $C_D$. The drop capacitance $C_D$ may be calculated or measured as described above. From the measured voltage $U_{in}$, an initial (saturation) drop voltage $U_D$ is calculated using the ratio of two capacitances according to $U_D = \dfrac{C_{in} + C_D}{C_D} U_{in} \approx \dfrac{C_{in}}{C_D} U_{in}$ for $C_{in} \gg C_D$.

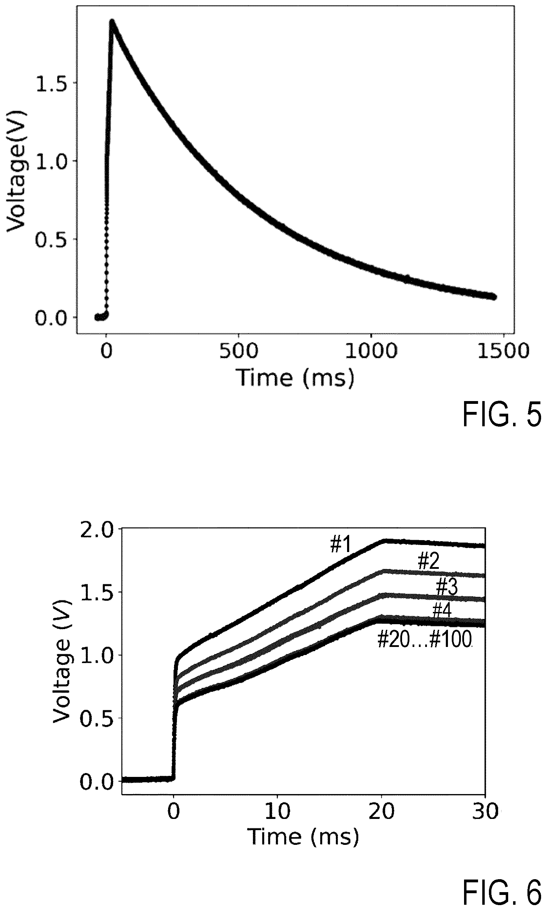

With a practical example, the input of the NI card may have a high input resistance of 100 G$\Omega$ and an input capacitance of 100 pF. Together with the cable 47, a total capacitance $C_{in}$ of the system of 1.35 nF can be measured, using an LCR meter and a discharge time and resistor (Figure 3). An additional resistor 48, e.g., 400 M$\Omega$, may be provided for discharging the input capacitor 45 after each measurement, while keeping the voltage stable during the drop contact. The discharge time of the input capacitor via the 400 M$\Omega$ resistor 48 is illustrated in exemplary manner in Figure 5.

Figure 6 illustrates experimental results of measuring the voltage $U_{in}$ vs time. The curves show voltages measured with one drop or a series of two or more drops 3. Each curve has an initial voltage jump within the first millisecond due to the redistribution of the drop charge across the total capacitance. It is followed by a linear voltage increase due to the ongoing charge separation at the moving contact line. After the drop has passed the electrode, the voltage signal shows a slow decrease. The initial voltage jump provides the voltage to be measured. Using the scaling factor in $U_D = \dfrac{C_{in}}{C_D} U_{in}$, the drop voltage $U_D$ can be calculated. With the above practical sample, the drop voltage at saturation is e.g., 1.1 kV.

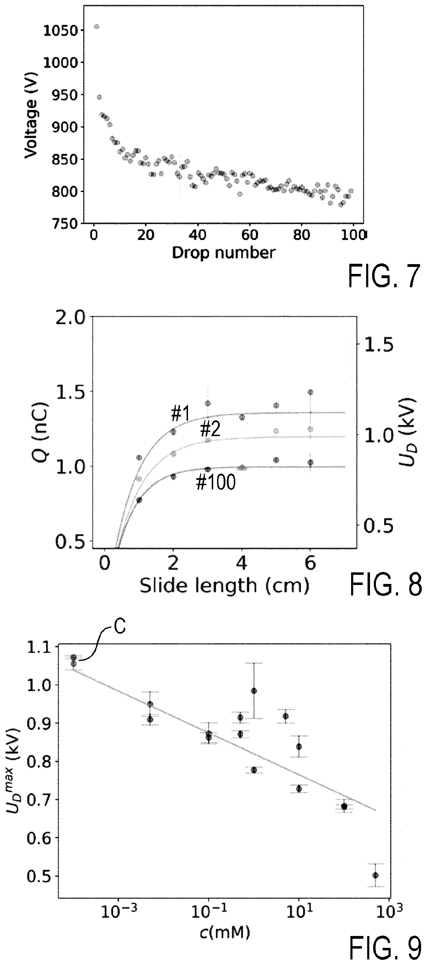

For determining the surface potential of the sample surface, measuring a single drop, in particular a first drop of a series of drops) may be sufficient. Alternatively, a series of drops may be measured, e.g., for compensating measuring errors and/or surface variations and improving statistics. However, when a series of drops is measured each sliding on the same sliding path, the measured voltage $U_{in}$ may be reduced from drop to drop towards a steady-state voltage as shown in Figure 6. Figure 7 correspondingly illustrates the calculated drop voltage $U_D$ for series of successive drops. Drop charge versus slide distance of the 1st, 2nd, and 100th drop, respectively, is plotted with an exponential fit in Figure 8. This voltage reduction and capacitance or charge change may result from substrate polarisation effects. It can be compensated by giving surface enough time (few seconds) to neutralize, e.g. 15 s., or it can be avoided by step-wise changing the sliding path on the sample surface for each subsequent drop (see e.g., Figure 12).

Figure 8 further illustrates that the charge collected by a drop sliding along the sliding path 4 depends on the length of the sliding path. The collected charge does not change, i.e., the saturation charge is obtained, if the length of the sliding path is above a saturation slide length of the sliding path 4. With the present practical example, the saturation slide length is e.g., $L_{sat}$ = 7.0 ± 0.3 mm.

As a result of the measurement with the potential measuring apparatus 100 of Figures 1 or 2, the drop voltage and/or drop charge is obtained. The calculation device 50 receives the drop voltage and/or drop charge as an input for calculating e.g., the surface potential of the sample-liquid interface. The output of the calculation device 50 provides the surface potential or related quantity to be obtained. The calculation device 50 comprises a computer circuit running a software program based on equations (7)/(8) and/or (9) derived from the quantitative model of charge transfer as follows.

The determination of the surface potential or related quantity to be obtained comprises a multiplication of the sensed saturation electric quantity. Depending on the configuration of the data acquisition device 44, this multiplication can be done by the data acquisition device 44 already, so that the data acquisition device 44 may simultaneously provide the calculation device 50.

Quantitative model of charge transfer

The quantitative model of charge transfer is described in particular with reference to Figure 10. Figure 10 illustrates the electrostatic potential $\Psi(z)$ between a metal electrode (e.g., Au) provided by the sample support 10, the sample 1 (e.g., glass) and the probe drop 3 (e.g., water). For an uncharged probe drop 3, the potential is flat throughout the substrate (dashed curve A). The surface charge density at the solid-liquid interface 2, $\sigma_{SL}$, is connected to a discontinuity in the dielectric displacement. For a charged drop (solid curve B) there is an electric field present in the sample 1, reducing the jump in the dielectric displacement and thereby the effective surface charge density.

For obtaining the quantitative model of charge transfer, the charge separation process is described by considering a single drop sliding on a neutral substrate. Because of charge conservation and the insulating nature of both the substrate and the surrounding air, any change in total drop charge, dQ, is the result of surface charges, $\sigma_{out}$, leaving the drop at the receding contact line of the drop. Thus, the change in drop charge of a drop with diameter w, sliding a distance of dx, at location x can be expressed as

$$dQ(x) = -\sigma_{\text{out}}(x)w dx \tag{1}$$

It is well known that solid surfaces in contact with liquid water acquire a net charge $\sigma_{SL}$ and form an electrostatic double layer (EDL) by attracting a diffuse layer of counter ions. The extension of this diffuse layer is called the Debye length $\lambda_D$ (see Figure 10). The surface charge can be caused by surface chemistry processes and/or specific ion adsorption [12]. The fundamental mechanism of charge separation at the receding contact line is the dewetting of bound surface charges from the EDL [14]. It is thus reasonable to assume that a fraction $0 \leq \alpha \leq 1$ of the surface charge is deposited by the drop [1]. Assuming $\alpha$ to be constant during the sliding drop measurement, the surface charges, $\sigma_{out}$ can be written

$$\sigma_{\text{out}} = \alpha \sigma_{SL} \tag{2}$$

To quantify $\sigma_{SL}$, Gauss' law at the solid- liquid interface is considered,

$$\sigma_{SL} = \mathbf{n} \left( \varepsilon_l \mathbf{E}_l - \varepsilon_s \mathbf{E}_s \right) \tag{3}$$

with the normal vector of the interface, n, and permittivity $\varepsilon$ and electric field E in the liquid (l) and solid (s), respectively. The electric field in the liquid, $E_l$, is governed by the EDL. For moderate surface potentials, $\Phi < kT/e$, the electric field in the liquid scales like $\mathbf{n}\mathbf{E}_l = \Phi/\lambda_D$. Here, k is the Boltzmann constant, T is temperature, e is the unit charge, and $\lambda_D$ is the Debye length.

For water with a monovalent salt at concentration $c_0$, it is given by $\lambda D = \sqrt{\varepsilon_l kT/(2c_0 e^2)}$. The electric field in the substrate, $E_s$, is determined by the potential difference between the drop with charge Q and the grounded plate under the sample 1 with thickness d (Figure 10), via $\mathbf{n}\mathbf{E_s} = - U_D/d$ ($C_D$: drop-sample capacitance). Overall, the interfacial Gauss' law yields

$$\sigma_{\mathrm{SL}} = \varepsilon_l \frac{\Phi}{\lambda_D} + \frac{\varepsilon_s}{d} U_D \tag{4}$$

This relationship is general, as it only contains the assumption of a moderate surface potential. However, equation 4 has two free variables: the solid-liquid surface charge $\sigma_{\mathrm{SL}}$ and surface potential $\Phi$.

Generally, a change in the drop potential could also shift the chemical equilibrium at the solid-liquid interface, thus generating a non-linear response of both $\sigma_{\mathrm{SL}}$ and $\Phi$ to the drop voltage $U_D$ [17, 18]. This potentially complex process can be linearized for an approximately constant potential drop across the diffuse layer and thus approximately constant surface potential. In this case, which corresponds to practical measuring conditions, the drop charge saturates as a function of distance, in agreement with the experimental result of Figure 8. Therefore, the linearization adequately captures the observed effects.

It is assumed that the voltage across the EDL is identical to the surface potential $\Phi$ of a neutral drop. Using the surface charge within the drop (equ. 4),

$$\sigma_{\mathrm{out}} = \alpha\, \sigma_{\mathrm{SL}} = \alpha \left( \varepsilon_l \frac{\Phi}{\lambda_D} + \frac{\varepsilon_s}{d} U_D \right) \tag{5}$$

is obtained.

Inserting into equation 1, the model equation for the drop charge is obtained:

$$dQ = -\alpha \left[ \frac{\varepsilon_l}{\varepsilon_s} \frac{d}{\lambda_D} \Phi + U_D(x) \right] c_s w dx \tag{6}$$

Here, $c_S = \varepsilon_S/d$ is the specific substrate capacitance. The drop charge will be stationary ($dQ = 0$) at a maximum drop voltage of

$$U_D^{\mathrm{max}} = -\chi \Phi \tag{7}$$

$$\chi = \frac{\varepsilon_l}{\varepsilon_s} \frac{d}{\lambda_D} \tag{8}$$

Thus, the saturation voltage, $U_D^{\mathrm{max}}$, is an electrostatically amplified value of the surface potential $\Phi$. The amplification factor $\chi$ is the ratio of the dielectric permittivities of liquid and sample and the ratio of sample thickness d and Debye length $\lambda_D$. Using values from the experiments ($\varepsilon_S = 7\varepsilon_0$, $\varepsilon_l = 80\varepsilon_0$, d = 1 mm, $\lambda_D \approx 400$ nm), a value of $\chi = 28571$ is obtained.

With the measured saturation value of $U_D^{\mathrm{max}} = 1.1$ kV, the surface potential of the measured sample can be calculated according to $\Phi \approx -38.0$ mV, which is close to the zeta-potential reported in literature for this combination of substrate and liquid [19].

By rearranging equation 8 and using the drop capacitance $C_D = \varepsilon_S A/d$, a similar relationship for the drop charge is obtained

$$Q_D = -\frac{\epsilon_l A}{\lambda_D} \Phi = -C_{EDL} \Phi \tag{9}$$

where $C_{EDL}$ is the EDL capacitance within the drop.

Thus, by measuring the saturated drop charge and/or voltage after sufficiently long slide distance, e.g., as described with reference to Figures 1 to 8, the surface potential of the solid-liquid surface can be determined based on equations (7)/(8) and/or (9) and additional predetermined information on the sample, like the dielectric permittivities, the sample thickness and the Debye length.

Advantageously, the proposed model is independent on the specific transfer coefficient $\alpha$. Once the drop has reached its steady state potential, no charge is transferred anymore to the substrate (see Figure 8). The transfer coefficient only determines the required characteristic saturation slide length employed to reach stated state.

For further explaining the charge transfer coefficient $\alpha$, equation 6 can be rearranged by using the drop capacitance $C_D = \varepsilon_s \pi w^2/(4d) = \varepsilon_s A/d$ and the maximum drop charge $Q^{max} = -\chi\Phi C_D$

$$\frac{dQ}{dx} + \frac{Q_D(x)}{L_{\text{sat}}} = \frac{Q_D^{max}}{L_{\text{sat}}} \tag{10}$$

Here, $L_{\text{sat}} = \frac{\pi w}{4\alpha}$ is the characteristic saturation slide length of the drop charge. With the measured saturation slide length of $L_{sat}$ = 7.0 ± 0.3 mm and a drop width of w = 5 mm, the charge transfer coefficient $\alpha \approx 0.5$ can be estimated.

Equation 8 predicts that the saturation drop voltage is proportional to the sample thickness, d. This linear function has been confirmed by experimental tests with different sample thicknesses. The voltage increase is the result of the lower drop capacitance on the thicker sample. The measured drop charge remained almost constant with different sample thicknesses.

Furthermore, the above model predicts a dependence of the saturation voltage on the Debye length - at least for moderate salt concentrations within the Debye-Hückel approximation. To test this dependence, the inventors performed experiments on the initial 1 mm thick sample using drops with different concentrations of $KNO_3$. The voltage measurements revealed a decreasing voltage with increasing ion concentration (Figure 9), which is consistent with literature [20]. With more details, Figure 9 shows the saturation voltage, $U_D{}^{max}$ with increasing $KNO_3$ concentration. Here, the dots C represent the maximum value of $U_D{}^{max}$ on the pristine surface without salt. The voltage generated by the drops was measured while increasing the salt concentration, and the surface was washed between each measurement. It is observed that the voltage decreases with increasing concentration (c). The decrease in $U_D{}^{max}$ can be described by $U_D^{max} \sim \Phi \sim log(\lambda_D)$ .

Modified embodiments of the invention

Figure 11 schematically illustrates a modified embodiment of the inventive potential measuring apparatus 100, wherein the sample support 10 is provided by a capillary and the sample 1 is provided by an inner surface of the capillary. The drop supply device 20 is arranged for placing a liquid probe drop 3 in the capillary. To this end, the drop supply device 20 may be configured as described with reference to Figures 1 and 2, in particular with the optional grounding electrode 23. The drop movement device 30 may comprise a gas pressure source coupled with an end of the capillary. By the effect of a gas pressure, e.g. air pressure, the probe drop 3 is driven through the capillary. The probe drop 3 is grounded at the grounding electrode 23 and moved along the sliding path 4 to the probe electrode 41 of the electrode measuring device 40. The electrode measuring device 40 may be configured as described with reference to Figures 1 and 2, and it may be coupled with and/or include the calculation device 50 for determining the physicochemical surface property to be obtained.

Alternatively, the drop movement device 30 of the embodiments of Figures 1/2 or 11 may be configured for a mechanical movement of the drop by the effect of a non-conductive tool, like a dielectric rod. According to a further alternative, the drop movement device 30 may be configured for a mechanical movement of the drop by the effect of a conductive tool, like a metal rod, which simultaneously can be used as probe electrode.

Features of another variant of the inventive potential measuring apparatus 100 are schematically illustrated in Figure 12 (top view of potential measuring apparatus 100). The drop supply device 20 is provided with a drive device 24 being configured for a mutual movement of the sample 1 to the drop supply device 20/the probe electrode 41 of the electrode measuring device 40 relative to each other. The drop supply device 20 and the probe electrode 41 can be arranged such that drops can be placed with the syringe 22 and grounded with the grounding electrode 23 and sensed with the probe electrode 41 at multiple parallel sliding paths (serial measurement, see dashed lines).

According to a further modification, the embodiment of Figure 12 may be configured for measuring multiple drops at multiple sliding paths in parallel, wherein each sliding path is provided with a separate drop supply device 20 and electrode measuring device 40 (as shown for one sliding path only).

Figure 13 illustrates a variant of the electrode measuring device 40 of an inventive potential measuring apparatus. With this embodiment, the electrode measuring device 40 is arranged for sensing the (saturation) drop voltage at the probe drop after passing the sliding path. Similar to the configuration of Figure 1, a current measuring component 43, like e.g., a current amplifier, is connected with the probe electrode 41 and with the data acquisition device 44. Additionally to the configuration of Figure 1, the measuring circuit 42 includes a variable voltage source 49 connected between the probe electrode 41 and the current measuring component 43 and further includes a control loop (see dashed arrow), e.g., a feedback PID control, for adjusting the voltage source 49 to a compensation voltage. The compensation voltage is set such that the current measuring component 43 does not sense a discharge current from the probe drop 3 moved on the sample 1. The compensation voltage even provides the drop voltage to be sensed, and it is output to the calculation device 50 for determining the surface potential.

The features of the invention disclosed in the above description, the drawings and the claims can be of significance both individually as well as in combination or sub-combination for the realization of the invention in its various embodiments. The invention is not restricted to the preferred embodiments described above. Rather a plurality of variants and derivatives is possible which also use the inventive concept and therefore fall within the scope of protection. In addition, the invention also claims protection for the subject and features of the sub claims independently of the features and claims to which they refer.

## Claims

1. Potential measuring apparatus (100), being configured for determining a physicochemical surface property based on a surface potential at a sample surface (2) of a solid sample (1), comprising

   - a sample support (10) being arranged for accommodating the sample (1),
   - a drop supply device (20) being arranged for placing a liquid probe drop (3) on the sample surface (2),
   - a drop movement device (30) being arranged for providing a sliding movement of the probe drop (3) along a predetermined sliding path (4) on the sample surface (2),
   - an electrode measuring device (40) being arranged for sensing an electrical quantity including at least one of a drop voltage and a drop charge of the probe drop (3) after passing the sliding path (4), wherein the electrode measuring device (40) includes a probe electrode (41) arranged at a downstream end of the sliding path (4) and a measuring circuit (42) coupled with the probe electrode (41), and
   - a calculation device (50) being adapted for determining the physicochemical surface property based on the electrical quantity.

2. Potential measuring apparatus according to claim 1, wherein

   - the calculation device (50) is adapted for determining the physicochemical surface property comprising at least one of the surface potential and a zeta potential of the sample surface (2).

3. Potential measuring apparatus according to one of the foregoing claims, wherein

   - the calculation device (50) is adapted for determining the physicochemical surface property, in particular the surface potential or the zeta potential, based on a proportional relationship between the surface potential or the zeta potential and the electrical quantity.

4. Potential measuring apparatus according to one of the foregoing claims, wherein

   - the drop movement device (30) comprises the sample support (10) being configured for accommodating the sample (1) with an inclined arrangement so that a surface normal direction of the sample surface (2) deviates from the gravity direction and the sample support (10) is arranged for creating the sliding movement of the probe drop (3) by gravity force.

5. Potential measuring apparatus according to claim 4, wherein

   - the sample support (10) is configured for accommodating the sample (1) with the inclined arrangement so that an inclination angle between the surface normal direction and the gravity direction is in a range between 20° to 70°.

6. Potential measuring apparatus according to one of the foregoing claims, wherein

   - the drop movement device (30) comprises a drop shifting device being configured for exerting a shifting force on the probe drop (3) and for creating the sliding movement of the probe drop (3) by the shifting force.

7. Potential measuring apparatus according to claim 6, wherein the drop shifting device comprises at least one of

- an electrically insulating shifting tool being arranged for contacting the probe drop (3) and exerting the shifting force on the probe drop (3), wherein at least one of the shifting tool and the sample support (10) are arranged for a movement relative to each other, and
- a pressure device being arranged for creating a pressure gradient along the sample surface (2) of the solid sample (1).

8. Potential measuring apparatus according to one of the foregoing claims, wherein

- the electrode measuring device (40) is arranged for sensing the drop charge of the probe drop (3) after passing the sliding path (4), and
- the measuring circuit (42) includes a current measuring component (43) and an integrator unit, wherein the current measuring component (43) is configured for measuring a discharge current from the probe drop (3) to the probe electrode (41) and the integrator unit is configured for integrating the measured discharge current.

9. Potential measuring apparatus according to one of the foregoing claims, wherein

- the electrode measuring device (40) is arranged for sensing the drop voltage at the probe drop (3) after passing the sliding path (4), and
- the measuring circuit (42) includes a probe capacitance connected between the probe electrode (41) and a reference potential, in particular ground potential, and a voltage acquisition circuit arranged for direct voltage measurement at the probe capacitance.

10. Potential measuring apparatus according to one of the foregoing claims, wherein

- the electrode measuring device (40) is arranged for sensing the drop voltage at the probe drop (3) after passing the sliding path (4), and
- the measuring circuit (42) includes a variable voltage source (49) connected with the probe electrode (41), a current measuring component (43) connected via the voltage source (49) with the probe electrode (41) and a control loop being arranged for adjusting the voltage source (49) to a compensation voltage such that the current measuring component (43) does not sense a discharge current from the probe drop (3), wherein the compensation voltage provides the drop voltage to be sensed.

11. Potential measuring apparatus according to one of the foregoing claims, comprising at least one of the features

- the drop supply device (20) comprises a drop dispenser,
- the probe electrode (41) is arranged with a distance from the sample surface (2),
- the probe electrode (41) comprises a wire-shaped, preferably tip-shaped, electrode with a wire section, preferably electrode tip, facing to the sliding path (4), and
- the drop supply device (20) comprises a drop shaping device being arranged for broadening the probe drop (3) placed on the sample surface (2).

12. Potential measuring apparatus according to one of the foregoing claims, wherein

- the drop supply device (20) is arranged for placing multiple liquid probe drops (3) on the sample surface (2),
- the drop movement device (30) is arranged for providing the sliding movement of each of the probe drops (3) along one or more predetermined sliding paths (4) on the sample surface (2), wherein each of the one or more sliding paths (4) is assigned to one of the probe drops (3),
- the electrode measuring device (40) is arranged for sensing the electrical quantity of each of the probe drops (3) after passing the corresponding sliding path (4), and
- the calculation device (50) is adapted for determining the physicochemical surface property based on the electrical quantities sensed with all of the probe drops (3).

13. Potential measuring method for determining a physicochemical surface property based on a surface potential at a sample surface (2) of a solid sample (1), comprising the steps of

- placing a liquid probe drop (3) on the sample surface (2),
- providing a sliding movement of the probe drop (3) along a predetermined sliding path (4) on the sample surface (2),

- sensing an electrical quantity including at least one of a drop voltage and a drop charge of the probe drop (3) after passing the sliding path (4), and
- determining the physicochemical surface property, in particular at least one of the surface potential and a zeta potential of the sample surface (2), based on the electrical quantity.

14. Potential measuring method according to claim 13, wherein

- the surface potential or the zeta potential is determined based on a proportional relationship between the surface potential or the zeta potential and the electrical quantity.

15. Potential measuring method according to one of the claims 13 to 14, wherein the sliding movement of the probe drop (3) is created by at least one of

- an inclined arrangement of the sample (1), so that the sliding movement of the probe drop (3) is created by gravity force, and
- exerting a shifting force on the probe drop (3) and creating the sliding movement of the probe drop (3) by the shifting force.

16. Potential measuring method according to one of the claims 13 to 15, wherein

- the drop charge at the probe drop (3) is sensed after passing the sliding path (4) by measuring a discharge current from the probe drop (3) to the probe electrode (41) and integrating the measured discharge current.

17. Potential measuring method according to one of the claims 13 to 16, wherein

- the drop voltage at the probe drop (3) is sensed after passing the sliding path (4) by connecting a probe capacitance between the probe electrode (41) and a reference potential, in particular ground potential, charging the probe capacitance with the probe drop (3) and measuring the drop voltage at the probe capacitance.

18. Potential measuring method according to one of the claims 13 to 17, wherein

- the drop voltage at the probe drop (3) is sensed after passing the sliding path (4) by applying a compensation voltage to the probe drop (3) such that no discharge current from the probe drop (3) occurs, wherein the compensation voltage provides the drop voltage to be sensed.

19. Potential measuring method according to one of the claims 13 to 18, comprising at least one of the features

- the sample surface (2) is a hydrophobic surface with a contact angle of at least 45°,
- the sample surface (2) is a plane surface,
- the sample surface (2) is a structured surface, e.g. including nanostructures, and
- the probe liquid comprises at least one of a polar liquid, in particular water or a watery solution, and an electrically conductive organic liquid.

FIG. 1

FIG. 2

FIG. 3

FIG. 4

FIG. 5

FIG. 6

FIG. 7

FIG. 8

FIG. 9

$$\Psi(z)$$

1

$$\sigma_{SL}$$    3

A

10

$$\Phi$$

$$U_D$$

2   $$\lambda_D$$

B

$$E_L = \zeta\kappa$$

$$E_S = U_D/d$$

z

d

FIG. 10

100

20    23     41    40   50

30

3

4

1, 10

FIG. 11

100

4
1

20 ○
22
23
24

40
41

FIG. 12

42
49

40
41
3
1
43
44
50

FIG. 13

## EUROPEAN SEARCH REPORT

**Application Number**

EP 23 21 1526

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | AMY Z. STETTEN ET AL: "Slide electrification: charging of surfaces by moving water drops", SOFT MATTER, vol. 15, no. 43, 6 November 2019 (2019-11-06), pages 8667-8679, XP093154126, GB ISSN: 1744-683X, DOI: 10.1039/C9SM01348B Retrieved from the Internet: URL:https://pubs.rsc.org/en/content/articl epdf/2019/sm/c9sm01348b> | 1,4-13, 15-19 | INV. G01N17/02 G01N27/60 G01R31/26 G01N27/00 |
| A | * the whole document * | 2,3,14 | |
| X | PRAVASH BISTA ET AL: "Adaptive two capacitor model to describe slide electrification in moving water drops", ARXIV.ORG, CORNELL UNIVERSITY LIBRARY, 201 OLIN LIBRARY CORNELL UNIVERSITY ITHACA, NY 14853, 8 February 2022 (2022-02-08), XP091157395, * abstract * * figures 1,4 * * pages 2-4, paragraph "The Adaptative Two Capacitor (A2C) Model" * | 1,13 | |
| A | KYOKO YATSUZUKA ET AL: "Electrification Phenomena of Pure Water Droplets Dripping and Sliding on a Polymer Surface", JOURNAL OF ELECTROSTATICS, ELSEVIER SCIENCE PUBLISHERS B.V. AMSTERDAM, NL, vol. 32, no. 2, 1 April 1994 (1994-04-01), pages 157-171, XP000446049, ISSN: 0304-3886, DOI: 10.1016/0304-3886(94)90005-1 * abstract * * figures 1-3 * * paragraph "2. Experimental method" * | 1-19 | TECHNICAL FIELDS SEARCHED (IPC) G01N G01R |

The present search report has been drawn up for all claims

| Place of search | Date of completion of the search | Examiner |
|---|---|---|
| Munich | 23 April 2024 | Ruchaud, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. Z. STETTEN ; D. S. GOLOVKO ; S. A. WEBER ; H.-J. BUTT**. *Soft Matter*, 2019, vol. 15, 8667
- **S. LIN et al.** *Nature communications*, 2020, vol. 11, 1
- **J. ZHANG et al.** *ACS nano*, 2021, vol. 15, 14830
- **L. E. HELSETH**. *Langmuir*, 2019, vol. 35, 8268
- **W. S. WONG et al.** *Langmuir*, 2020, vol. 36, 7236
- **R. ZIMMERMANN et al.** *Physical Chemistry Chemical Physics*, 2009, vol. 11, 4360
- **K. N. KUDIN et al.** *Journal of the American Chemical Society*, 2008, vol. 130, 3915
- **L. S. MCCARTY et al.** *Angewandte Chemie International Edition*, 2008, vol. 47, 2188
- **M. D. SOSA et al.** *Soft Matter*, 2020, vol. 16, 7040
- **M. KOWACZ et al.** *The Journal of Physical Chemistry B*, 2019, vol. 123, 11003
- **R. J. HUNTER**. Foundations of Colloid Science. Oxford University Press, 2001, 356-361
- **H.-J. BUTT et al.** Physics and Chemistry of Interfaces. Wiley-VCH, 2006, 45-59
- **M. D. SOSA et al.** *Langmuir*, 2022, vol. 38, 8817
- **A. D. RATSCHOW et al.** *How charges separate when surfaces are dewetted*, 2023
- **T. HIEMSTRA et al.** *Journal of colloid and interface science*, 1989, vol. 133, 105
- **S. CHEN et al.** *Sensors*, 2020, vol. 20, 1690
- **S. H. BEHRENS et al.** *The Journal of chemical physics*, 2001, vol. 115, 6716
- **E. J. VAN DER WOUDEN et al.** *Lab on a chip*, 2006, vol. 6, 1300
- **P. VOGEL et al.** *Journal of the American Chemical Society*, 2022, vol. 144, 21080
- **L. E. HELSETH**. *Langmuir*, 2023, vol. 39, 1826
- **B. J. KIRBY et al.** *Electrophoresis*, 2004, vol. 25, 187
- **D. I. DIAZ et al.** Charging of impacting drops onto superhydrophobic surfaces. *Soft Matter*, 2022, vol. 18